# EUROPÄISCHE PATENTANMELDUNG

(11) **EP 0 749 055 A2**
(43) Veröffentlichungstag der Anmeldung: **18.12.1996**
(21) Anmeldenummer: 96108908.3
(22) Anmeldetag: 04.06.1996
(51) Int. Cl.: G04G 7/02

(54) **Überlagerungsempfänger mit Synchrondemodulation für den Zeitzeichenempfang**

(30) Priorität: 16.06.1995 DE 19521908
(71) Anmelder: TEMIC TELEFUNKEN microelectronic GmbH, 74072 Heilbronn (DE)
(72) Erfinder: Böhme, Rolf, Dr., 74177 Bad Friedrichshall (DE); Eichin, Matthias, D-74080 Heilbronn (DE)
(74) Vertreter: Maute, Hans-Jürgen, Dipl.-Ing.

(57) **Zusammenfassung**

Es wird ein Überlagerungsempfänger nach dem Prinzip der Synchrondemodulation für den Zeitzeichenempfang beschrieben, bei dem ein erster Mischer vom ersten Phasenregelkreis angesteuert wird, der von einer Referenzquarzquelle und einem umschaltbaren Vorladewert gespeist wird.
Durch umschaltbare Frequenzteiler sowie mittels der Vorladewerte lassen sich international unterschiedliche Zeitgeberfrequenzen (JP: 40 kHz; USA/GB: 60 kHz; EU/D: 77,5 kHz) verarbeiten und auf die Zwischenfrequenzen umsetzen. Diese werden dann mittels eines zweiten Mischers synchron demoduliert, welcher sein Signal vom zweiten Phasenregelkreis erhält, der durch das Zwischenfrequenzsignal über den Phasenkomparator, aber auch das Regelsignal des Phasenregelkreises angesteuert wird und so nur noch einen Restfehlerabgleich durchführen muß.

## Beschreibung

Die vorliegende Erfindung betrifft einen Überlagerungsempfänger mit Synchrondemodulation für den Empfang der Funksignale eines Zeitzeichensenders gemäß dem Oberbergriff des Anspruchs 1.

In der Druckschrift DE 41 25 995 A1 ist ein Überlagerungsempfänger, der nach dem Prinzip der Synchrondemodulation arbeitet, beschrieben. In diesem wird in einer Vorsynchronisationsphase eine steuerbare Oszillatoranordnung über einen ersten Regelkreis mit Hilfe einer Referenzfrequenzquelle, in der Regel der Oszillator einer autonomen Quarzuhr mit der Frequenz 32768 Hz, auf einen Sollwert der Oszillatorfrequenz vorsynchronisiert. Danach wird durch Umschalten auf einen zweiten Regelkreis auf das empfangene Nutzsignal synchronisiert. Bei einer Synchrondemodulation wird die Frequenzselektion durch nachgeschaltete Tiefpässe statt eines (Quarz-)Bandfilters ausgeführt. Gemäß DE 41 25 995 A1 wird das Eingangssignal zunächst auf eine Zwischenfrequenz umgesetzt, um eine unerwünschte Störbeeinflussung des Antennensignals durch das Oszillatorsignal zu vermeiden.

Um in der Vorsynchronisationsphase die Empfangsfrequenz des Empfängers mit Hilfe der Referenzfrequenz möglichst genau auf den Sollwert zu bringen, sind aufwendige Frequenzteiler erforderlich. Aufwand und Flächenbedarf in einer integrierten Schaltung sowie der Strombedarf wirken sich dabei negativ aus. Verschärft wird dieser Nachteil, wenn der Empfänger für mehrere Empfangsfrequenzen vorgesehen werden soll, weil dann der Aufwand für die Steuerung weiter ansteigt. Die verhältnismäßig groben Toleranzen bei der Herstellung integrierter Schaltkreise haben zur Folge, daß ein großer Fangbereich für die Vorsynchronisation erforderlich ist. Demgegenüber ist für das Nutzsignal aus Gründen des Störabstandes ein wesentlich kleinerer Fangbereich vorzusehen. Das hat aber den Nachteil, daß bei einem kurzzeitigen Ausfall des Senders oder einer Störung die Synchronisation meist verlorengeht und die Empfangsbereitschaft durch eine erneute Vorsynchronisation wieder aufgebaut werden muß.

Der Erfindung liegt die Aufgabe zugrunde, einen Überlagerungsempfänger mit Synchrondemodulation anzugeben, der keine Vorsynchronisation benötigt, nach Störungen oder Senderausfällen sofort wieder betriebsfähig ist und die Umschaltung zwischen verschiedenen Senderfrequenzen mit geringem Mehraufwand erlaubt.

Diese Lösung ist mit den kennzeichnenden Merkmalen des Patentanspruchs 1 gegeben. Hiernach wird ein Überlagerungsempfänger nach dem Prinzip der Synchrondemodulation für den Zeitzeichenempfang beschrieben, bestehend aus einer Eingangsstufe, einem ersten Mischer, der mittels eines ersten, umschaltbaren Phasenregelkreises angesteuert wird, welcher von einer Referenzquarzquelle geführt wird, einem Bandpaß für die erzeugte Zwischenfrequenz und einem zweiten Mischer für den direktmischenden Synchrondemodulator mit nachgeschalteter Ausgangsschaltung, wobei die Frequenz des zweiten Mischers durch einen zweiten Phasenregelkreis erzeugt wird und das Regelsignal des zweiten Phasenregelkreises unter Zuhilfenahme des Regelsignals des ersten Phasenregelkreises gebildet wird.

Damit wird ein vorsynchronisationsfreier Überlagerungsempfänger realisiert, der sich durch vollständige integrierbarkeit und durch die Empfangsmöglichkeit mehrerer Zeitzeichensender (Mehrbereichsempfang) auszeichnet.

Vorteilhafte Weiterbildungen sind in den Patentansprüchen 2 bis 15 gegeben.

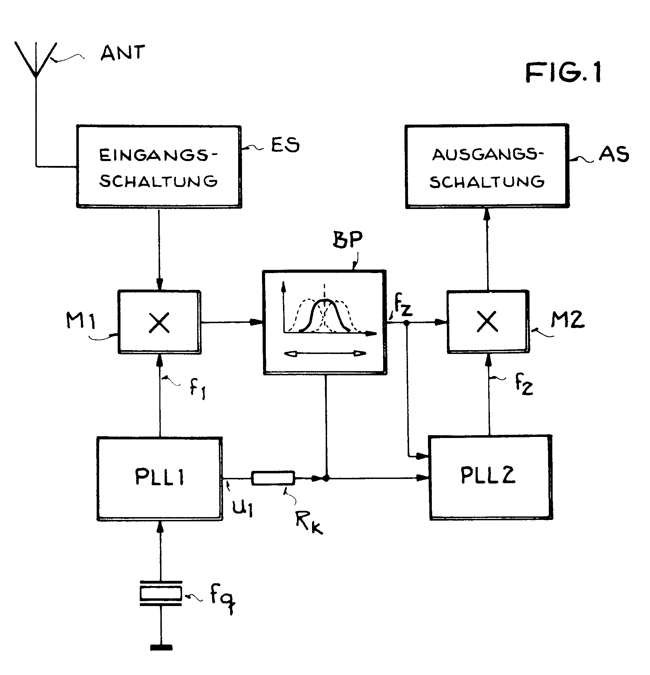

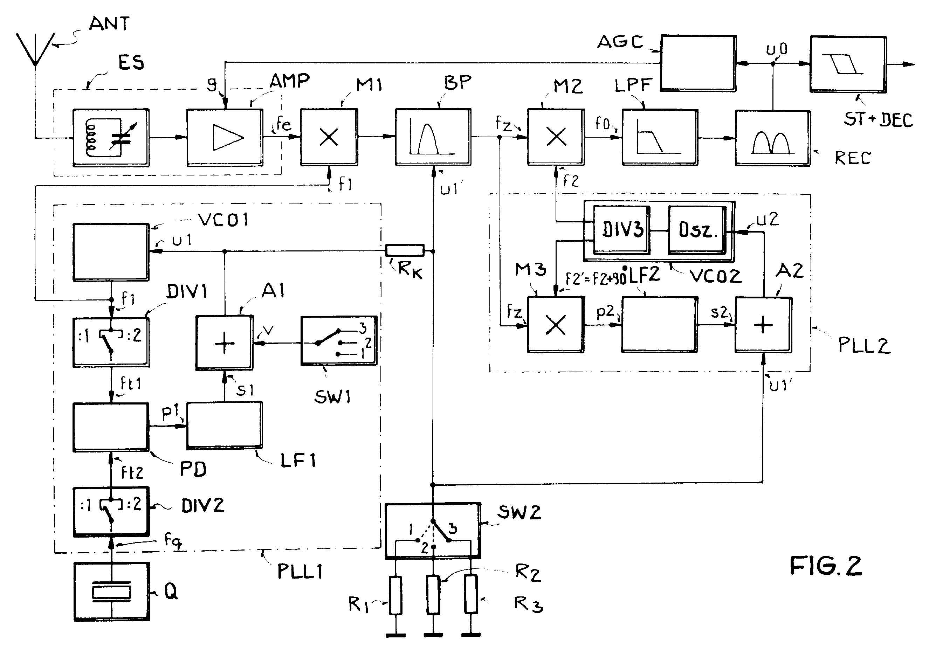

Die Erfindung wird nachfolgend anhand von Ausführungsbeispielen im Zusammenhang mit den Figuren 1 und 2 erläutert. Es zeigen:
- Figur 1: ein Blockschaltbild des erfindungsgemäßen Empfängers und
- Figur 2: ein Schaltbild des Ausführungsbeispieles nach Figur 1.

Figur 1 zeigt im Blockschaltbild das Prinzip der erfindungsgemäßen Schaltung. Über eine Antenne wird das Zeitzeichensignal empfangen und an eine Eingangsschaltung ES weitergeleitet. Von dort aus gelangt das Signal in einen ersten Mischer M1, wo es um eine Frequenz f1 umgesetzt wird, die von einem ersten Phasenregelkreis PLL1 gebildet wird, wobei der Phasenregelkreis PLL1 selbst von einer Referenzquelle fq geführt wird. Durch nachfolgende Bandpaßfilterung mittels eines Bandpasses BP erhält man ein Zwischenfrequenzsignal fz. Dieses wird in einem zweiten Mischer M2 synchron demoduliert und an eine Ausgangsschaltung AS weitergeleitet. Zum Zwecke der Synchrondemodulation erzeugt ein zweiter Phasenregelkreis PLL2 eine den zweiten Mischer M2 speisende Ausgangsfrequenz f2 = fz, die mit der Zwischenfrequenz fz synchronisiert ist. Um die Herstellung der Synchronisation zu erleichtern und sie über schwierige Empfangsbedingungen aufrechtzuerhalten, wird dem Regelsignal des zweiten Phasenregelkreises PLL2 ein durch den Widerstand Rk gewichteter Teil des Regelsignales u1 des ersten Phasenregelkreises PLL1 hinzugefügt (wobei die Wichtung ebenso durch eine andere Methode, z. B. über ein Flächenverhältnis, erfolgen kann). Es ist auch vorgesehen, daß ein gewichteter Teil des Regelsignals u1 dem Bandpaß BP zugeführt wird. Dies ist insbesondere dann zweckmäßig, wenn der Bandpaß BP mit ähnlichen schaltungstechnischen Mitteln wie der gesteuerte Oszillator des zweiten Phasenregelkreises ausgeführt ist und auf gleiche Weise steuerbar ist.

Nachfolgend wird die schaltungsmäßige Ausführung des Blockschaltbildes anhand der Figur 2 beschrieben:

Das von der Antenne ANT aufgenommene Funkempfangssignal wird in einem steuerbaren Verstärker AMP mit einstellbarem Verstärkungsgrad verstärkt und dem ersten Mischer M1 zur Umsetzung in eine Zwischenfrequenzlage zugeführt. Das hierfür notwendige Überlagerungssignal f1 wird in einem ersten Phasenregelkreis PLL1 erzeugt. Der Phasenregelkreis PLL1 besteht aus einem steuerbaren Oszillator VCO1, dessen Regelsignal u1 einem Addierer A1 entnommen wird, der ein Signal von einem Phasenkomparator PD über ein Schleifenfilter LF1 und ein zweites Signal als Vorladewert v aus einer umschaltbaren Quelle SW1 erhält. Der erste Eingang des Phasenkomparators PD ist mit dem Ausgang des steuerbaren Oszillators VCO1 über einen Frequenzteiler DIV1 verbunden, der vorzugsweise auf die Teilerfaktoren 1 und 2 eingestellt werden kann. Dem zweiten Eingang des Phasenkomparators PD ist ebenfalls ein Frequenzteiler DIV2 mit gleichen Eigenschaften vorgeschaltet, der von einer Referenzquelle Q gespeist wird.

Der erste Mischer M1 führt das verstärkte Eingangssignal fe in ein Zwischenfrequenzsignal fz über, das in einem Bandpaß BP gefiltert wird. Danach wird das Zwischenfrequenzsignal fz durch Mischung mit einem phasenrichtigen Überlagerungssignal f2 in einem zweiten Mischer M2 synchron demoduliert (Gleichrichtung). Ein zweiter Phasenregelkreis PLL2 generiert dieses Überlagerungssignal f2.

Der zweite Phasenregelkreis PLL2 besteht aus einem steuerbaren Oszillator VCO2. Der steuerbare Oszillator VCO2 weist zwei Ausgänge auf, die zwei um 90° versetzte Ausgangssignale f2, f2' liefern. Dies kann auch durch einen nachgeschalteten Frequenzteiler DIV3 erreicht werden. Das Regelsignal u2 des Oszillator VCO2 wird einem Addierer A2 entnommen. Der Addierer A2 erhält ein Signal s2 von einem Phasenkomparator M3 über ein Schleifenfilter LF2 und den gewichteten Teil u1' des Regelsignals u1. Der erste Eingang des Phasenkomparators M3 ist mit dem zweiten Ausgang des steuerbaren Oszillators VCO2 verbunden. Der zweite Eingang des Phasenkomparators M3 ist mit dem Ausgang des Bandpasses BP verbunden.

Alternativ dazu kann der Bandpaß BP mit zwei Ausgängen für zwei zueinander um 90° phasenverschobene Signale ausgestattet sein, während der steuerbare Oszillator VCO2 nur einen Ausgang besitzt.

Das Regelsignal u1' wird aus dem Regelsignal u1 des ersten Phasenregelkreises PLL1 gebildet, indem es durch einen Widerstand Rk oder eine andere Methode gewichtet wird. Falls für die Signalwerte Spannungen vorgesehen sind, kann u1' aus u1 über einen umschaltbaren Spannungsteiler SW2 gebildet werden. Je nach den vorgesehenen Empfangsfrequenzen wird die Umschaltung der Frequenzteiler DIV1 und DIV2, der umschaltbaren Quelle SW1 und des umschaltbaren Spannungsteilers SW2 miteinander koordiniert, wie weiter unten noch näher ausgeführt wird.

Das Ausgangssignal f0 des Mischers M2 enthält eine Gleichkomponente entsprechend der Signalamplitude, die im nachfolgenden Tiefpaß LPF von unerwünschten Signalkomponenten befreit wird. Um im Falle des nichtgerasteten Betriebs, wenn der Mischer M2 keine Gleichkomponente abgibt, die Verstärkungsregelung aufrechtzuerhalten, ist dem Tiefpaß LPF ein Gleichrichter bzw. Absolutwertbildner REC zugefügt. Die Zeitinformationen, die aus Amplitudenabsenkungen verschiedener Dauer besteht, wird in einer Schaltung ST mit Schmitt-Trigger-Verhalten in zweiwertige Datensignale umgeformt und in einem Dekoder DEC dekodiert.

Aus dem gleichgerichteten Signal u0 am Ausgang des Gleichrichters REC wird in an sich bekannter Weise in einer Hilftsschaltung AGC die Steuerspannung g für die Einstellung des steuerbaren Verstärkers AMP gebildet.

Für die im Ausführungsbeispiel gemäß Figur 2 vorgesehenen Empfangsfrequenzen (40 kHz, 60 kHz und 77,5 kHz) werden entsprechend drei Zwischenfrequenzen erzeugt. Angestrebt wird ein Wert der Zwischenfrequenz im Bereich um 5 kHz, weil dies einen guten Kompromiß zwischen Spiegelwellenselektion und Selektivität des Bandpasses BP darstellt. Die Teiler DIV1 und DIV2 sowie die umschaltbare Quelle SW1 des ersten Phasenregelkreises PLL1 werden in Abhängigkeit von der gewünschten Empfangsfrequenz eingestellt. Die Frequenz des gesteuerten Oszillators VCO1 wird aber nicht nur von der Referenzfrequenz fq und den Teilerfaktoren bestimmt, sondern auch vom Vorladewert v, der vom Umschalter SW1 eingestellt wird und der ein Einrasten auf eine ungeradzahlige Harmonische bewirken kann. Z. B. ist für die erste Empfangsfrequenz von 77,5 kHz vorgesehen, daß der erste Teiler DIV1 auf den Teilerfaktor eins, der zweite Teiler DIV2 auf den Teilerfaktor zwei gestellt und der Vorladewert v der umschaltbaren Quelle SW1 den steuerbaren Oszillator VCO1 näherungsweise auf die fünfte Harmonische der halben Referenzfrequenz fq/2 stellt. Damit bewirkt diese Einstellung ein Einrasten auf eine Sollfrequenz 81,92 kHz des VCO1.

Für die zweite Empfangsfrequenz von 60 kHz, bei der der Oszillator VCO1 auf der Grundwelle rastet, wird der erste Teiler DIV1 auf den Teilerfaktor zwei, der zweite Teiler DIV2 auf den Teilerfaktor eins gestellt. Der steuerbare Oszillator VCO1 stellt sich unter diesen Bedingungen auf die doppelte Referenzfrequenz 2*fq = 65,536 kHz, was durch geeignete Wahl des Vorladewertes v der umschaltbaren Quelle SW1 eingeleitet wird.

Die dritte Empfangsfrequenz von 40 kHz benötigt eine Einstellung des ersten Teilers DIV1 und des zweiten Teilers DIV2 auf den Teilerfaktor eins. Bei Wahl eines Vorladewertes v der umschaltbaren Quelle SW1, der den steuerbaren Oszillator VCO1 auf die Referenzfrequenz fq selbst stellt, wird ein Einrasten auf die Sollfrequenz 32,768 kHz erreicht.

Die Einstellung des ersten Oszillators VCO1 über den Phasenregelkreis aus der äußeren Referenzfrequenz fq sichert dessen Frequenz f1 unabhängig von den integrationstypischen Toleranzen. Abweichungen vorn Sollwert sind nur möglich, wenn die Referenzfrequnz abweicht oder wenn der Phasenregelkreis nicht rastet, was einen Funktionsausfall bedeuten würde. Das Regelsignal u1 des gesteuerten Oszillators VOC1 ist aber nach dessen präziser Einstellung von den Toleranzen der IC-Elemente abhängig. Da aber bei gleichartigem Entwurf alle Oszillatoren und Filter gleichartig tolerieren, kann das Regelsignal u1 als Referenz für die Einstellung übriger selektiver Funktionseinheiten verwendet werden. Unter der Voraussetzung einer linearen Steuerfunktion, die sich z. B. bei einer Transkonduktanzsteuerung verhältnismäßig genau realisieren läßt, können die an das Regelsignal u1 angekoppelten Funktionseinheiten über Teiler oder Verstärker auf Teile oder Vielfache der Bezugsfrequenz f1 eingestellt werden. Abweichungen treten dann nur noch im Rahmen der relativen Toleranzen innerhalb der integrierten Schaltung auf, die etwa zwei Größenordnungen kleiner als die absoluten sein können. Für die Voreinstellung des steuerbaren Oszillators VCO2 bedeutet das, daß dieser verhältnismäßig genau auf seine Sollfrequenz gestellt werden kann und daß der zweite Phasenregeikreis PLL2 nur einen kleinen Fangbereich benötigt. Dadurch vermeidet man, daß das System auf eine in der Nähe der Empfangsfrequenz befindliche Störfrequenz einrasten kann.

Für den Fall, daß die Steuersignale in Form von Spannungen vorliegen, zeigt Figur 2 die Bewertung durch den umschaltbaren Spannungsteiler SW2. Je nach eingestellter Empfangsfrequenz werden die Widerstände R1 bis R3 in Serie zu Widerstand Rk geschaltet und so das Regelsignal u1' zur Steuerung der Mittenfrequenz des Bandpasses BP und zur Voreinstellung des steuerbaren Oszillators VCO2 generiert.

## Patentansprüche

1. Überlagerungsempfänger nach dem Prinzip der Synchrondemodulation für den Zeitzeichenempfang, bestehend aus einer Eingangsschaltung (ES), einem ersten Mischer (M1), der mittels eines ersten Phasenregelkreises (PLL1) angesteuert wird, welcher von einer Referenzquelle (fq) geführt wird, einem Bandpaß (Bp) und einem zweiten Mischer (M2) für den direktmischenden Synchrondemodulator (M2, PLL2) mit nachgeschalteter Ausgangsschaltung (AS), wobei der Bandpaß (Bp) eine Zwischenfrequenz (fz) dem zweiten Mischer (M2) zuführt, dadurch gekennzeichnet, daß die Frequenz (f2) des zweiten Mischers (M2) durch einen zweiten Phasenregelkreis (PLL2) erzeugt wird und daß das Regelsignal des zweiten Phasenregelkreises (PLL2) aus der Zwischenfrequenz (fz) und dem Regelsignal (u1) des ersten Phasenregelkreises (PLL1) gebildet wird.

2. Überlagerungsempfänger nach Anspruch 1, dadurch gekennzeichnet, daß im ersten Phasenregelkreis (PLL1) das Regelsignal (u1) aus einem Vorladewert (v) und dem Ausgangssignal (p1) eines Phasenkomparators (PD) gebildet wird.

3. Überlagerungsempfänger nach Anspruch 2, dadurch gekennzeichnet, daß der Vorladewert (v) je nach Empfangsfrequenz umgeschaltet bzw. gesteuert wird.

4. Überlagerungsempfänger nach einem der Ansprüche 1 bis 3, dadurch gekennzeichnet, daß der zweite Phasenregelkreis (PLL2) einen gesteuerten Oszillator (VCO2) mit zwei Ausgängen aufweist, die zwei um 90° versetzte Ausgangssignale (f2, f2') liefern.

5. Überlagerungsempfänger nach Anspruch 4, dadurch gekennzeichnet, daß der gesteuerte Oszillator (VCO2) aus einem primären Oszillator (OSZ) und einem nachgeschalteten Frequenzteller (DIV3) besteht und daß der Frequenzteiler (DIV3) zwei Ausgänge aufweist, die zwei um 90° versetzte Ausgangssignale (f2, f2') liefern.

6. Überlagerungsempfänger nach einem der Ansprüche 4 oder 5, dadurch gekennzeichnet, daß der erste Ausgang (f2) des gesteuerten Oszillators (VCO2) mit dem zweiten Mischer (M2) und der zweite Ausgang (f2') des gesteuerten Oszillators (VCO2) mit dem Phasenkomparator (M3) des zweiten Phasenregelkreises (PLL2) verbunden ist.

7. Überlagerungsempfänger nach einem der Ansprüche 1 bis 6, dadurch gekennzeichnet, daß aus dem Regelsignal (u1) des ersten Phasenregelkreises (PLL1) durch Teilung oder Verstärkung und/oder Umschaltung ein bewertetes Regelsignal (u1') gebildet wird.

8. Überlagerungsempfänger nach Anspruch 6, dadurch gekennzeichnet, daß eine Summierschaltung (A2) vorgesehen ist, deren erster Eingang das Ausgangssignal (p2, s2) des Phasendetektors (M3) des zweiten Phasenregelkreises (PLL2), deren zweiter Eingang das bewertete Regelsignal (u1') des ersten Phasenregelkreises (PLL1) erhält und deren Ausgang (u2) mit dem Steuereingang des Oszillators (VCO2) verbunden ist.

9. Überlagerungsempfänger nach einem der Ansprüche 1 bis 8, dadurch gekennzeichnet, daß die Mittenfrequenz des Bandpasses (BP) elektronisch steuerbar ist.

10. Überlagerungsempfänger nach Anspruch 9, dadurch gekennzeichnet, daß die Mittenfrequenz des Bandpasses (BP) vom bewerteten Regelsignal (u1') des ersten Phasenregelkreises (PLL1) gesteuert wird.

11. Überlagerungsempfänger nach einem der Ansprüche 1 bis 10, dadurch gekennzeichnet, daß der Ausgang (f1) des gesteuerten Oszlllators (VCO1) des ersten Phasenregelkreises (PLL1) mit dem Eingang eines ersten Teilers (DIV1) verbunden ist, der sich auf die Teilerfaktoren 1 und 2 umschalten läßt und dessen Ausgang (ft1) an den ersten Eingang des Phasenkomperators (PD) angeschlossen ist.

12. Überlagerungsempfänger nach Anspruch 11, dadurch gekennzeichnet, daß der Ausgang (fq) der Referenzfrequenz (Q) des ersten Phasenregelkreises (PLL1) mit dem Eingang eines zweiten Teilers (DIV2) verbunden ist, der sich auf die Teilerfaktoren 1 und 2 umschalten läßt und dessen Ausgang (ft2) an den zweiten Eingang des Phasenkomperators (PD) angeschlossen ist.

13. Überlagerungsempfänger nach Anspruch 12, dadurch gekennzeichnet, daß das Ausgangssignal (f1) des ersten Phasenregelkreises (PLL1) bei einer Empfangsfrequenz (fe) von 77,5 kHz den wert 81,92 kHz besitzt, daß der erste Teiler (DIV1) auf den Teilerfaktor 1 und der zweite Teiler (DIV2) auf den Teilerfaktor 2 gestellt ist.

14. Überlagerungsempfänger nach Anspruch 12, dadurch gekennzeichnet, daß das Überlagerungssignal (f1) des ersten Phasenregelkreises (PLL1) bei einer Empfangsfrequenz (fe) von 60 kHz den Wert 65,536 kHz besitzt, daß der erste Teiler (DIV1) auf den Teilerfaktor 2 und der zweite Teiler (DIV2) auf den Teilerfaktor 1 gestellt ist.

15. Überlagerungsempfänger nach Anspruch 12, dadurch gekennzeichnet, daß das Überlagerungssignal (f1) des ersten Phasenregelkreises (PLL1) bei einer Empfangsfrequenz (fe) von 40 kHz den Wert 32,768 kHz besitzt, daß der erste Teiler (DIV1) auf den Teilerfaktor 1 und der zweite Teiler (DIV2) auf den Teilerfaktor 1 gestellt ist.
